# EUROPÄISCHE PATENTANMELDUNG

(11) **EP 2 447 991 A2**
(43) Veröffentlichungstag der Anmeldung: **02.05.2012**
(21) Anmeldenummer: 11181609.6
(22) Anmeldetag: 16.09.2011
(51) Int. Cl.: H01L 23/31, H01L 23/495, H01L 21/48

(54) **Kontaktelement und Verwendung eines Kontaktelements in einem elektronischen Bauteil**

(30) Priorität: 13.10.2010 DE 102010042382
(71) Anmelder: Robert Bosch GmbH, 70442 Stuttgart (DE)
(72) Erfinder: Gradtke, Oliver, 72766 Reutlingen (DE)

(57) **Zusammenfassung**

Es wird ein Kontaktelement (10) vorgeschlagen, bei dem Entlastungsstrukturen in Form von Federelementen (20) ausgebildet sind. In einem ersten Abschnitt (12), der zur elektrischen Kontaktierung eines elektronischen Bauelements (100) vorgesehen ist, ist erfindungsgemäß mindestens eine Ausnehmung (25) vorgesehen. Die Ausnehmung ist von einem Rahmenbereich (13) vollständig oder weitestgehend umgeben und enthält mindestens ein Federelement (20), wobei das Federelement (20) mit dem Rand (13') des Rahmenbereichs (13) verbunden ist. In direkter Verbindung mit einem Federelement (20), bevorzugt an dessen freiem Ende, ist jeweils ein Kontaktbereich (30) ausgebildet, an dem, beispielsweise durch Löten, der elektrische Kontakt zwischen dem Kontaktelement (10) und einem elektronischen Bauelement (100) hergestellt werden kann.

## Beschreibung

Die Erfindung betrifft ein Kontaktelement nach dem Oberbegriff des Anspruchs 1.

### Stand der Technik

In herkömmlichen elektrischen oder elektronischen Bauteilen werden Kontaktelemente eingesetzt, die als Stanzblechteile ausgeführt sind. Diese Kontaktelemente weisen Kontaktbereiche auf, die auf entsprechende Kontaktflächen von elektrischen oder elektronischen Bauteilen aufgelötet oder mit einem elektrisch leitfähigen Klebstoff aufgeklebt werden können. Halbleiterbauelemente, wie IGBTs, MOSFETs oder ähnliches besitzen oft Kontaktflächen auf mehreren Oberflächen. Derartige Bauelemente werden typischerweise auf ein erstes Kontaktelement, das als Leiterrahmen ("Leadframe") ausgebildet ist, aufgelötet. Ein zweites Kontaktelement, das als Kontaktbügel ausgeführt ist, wird auf der Oberfläche des Bauelements kontaktiert. Zum Schutz der Kontaktstellen wird anschließend das Bauelement mit Kunststoff umgossen, ein Vorgang, der auch als "Ummolden" bezeichnet wird. Da die Materialen des elektronischen Bauelements (Silizium) und der Kontaktelemente (Kupfer) große Unterschiede in ihren thermischen Ausdehnungskoeffizienten aufweisen, wirken bei Temperaturwechsel starke Scherkräfte auf die Kontaktstellen zwischen dem Bauelement und dem jeweiligen Kontaktelement. Um eine Zerrüttung der Kontaktstellen zu vermeiden, schützt die Ummoldung die Kontaktstellen.

Aus der US 6,075,286 ist ein Kontaktelement bekannt, dass zusätzliche Strukturen zur Entlastung der Kontaktstellen aufweist. Diese Strukturen sind durch Einschnitte am Rand des Kontaktelements gebildet und werden ebenfalls ummoldet.

### Offenbarung der Erfindung

Es wird ein Kontaktelement vorgeschlagen, bei dem Entlastungsstrukturen in Form von Federelementen ausgebildet sind. In einem ersten Abschnitt, der zur elektrischen Kontaktierung eines elektronischen Bauelements vorgesehen ist, ist dazu erfindungsgemäß mindestens eine Ausnehmung vorgesehen. Die Ausnehmung ist von einem Rahmenbereich vollständig oder weitestgehend umgeben und enthält mindestens ein Federelement, wobei das Federelement mit dem Rand des Rahmenbereichs verbunden ist. In direkter Verbindung mit einem Federelement, bevorzugt an dessen freiem Ende, ist jeweils ein Kontaktbereich ausgebildet, an dem, beispielsweise durch Löten, der elektrische Kontakt zwischen dem Kontaktelement und einem elektronischen Bauelement hergestellt werden kann. Dadurch ergibt sich der Vorteil, dass das Kontaktelement, trotz der ausgebildeten Federelemente eine einfache Kontur behält und in einfacher Weise montiert werden kann.

Die Erfindung betrifft weiterhin die Verwendung eines derartigen Kontaktelements in einem elektronischen oder elektrischen Bauteil, zur Kontaktierung eines elektronischen Bauelements. Das erfindungsgemäß ausgestaltete Kontaktelement eignet sich insbesondere zur Kontaktierung von Halbleiterbauelementen, aber auch andere elektrische bzw. elektronische Bauelemente, wie beispielsweise Keramikkondensatoren oder Drosseln, können mittels eines derartigen Kontaktelements kontaktiert werden.

Dazu werden die Kontaktbereiche, die mit den Federelementen des Kontaktelements verbunden sind, mit entsprechenden Kontaktflächen auf einer Oberfläche des elektronischen Bauelements elektrisch kontaktiert. Durch die Federelemente können mechanische Spannungen, die beispielsweise durch die unterschiedlichen thermischen Ausdehnungskoeffizienten des Kontaktelements und des elektronischen Bauteils entstehen, kompensiert werden. Die Kontaktstellen sind damit vor Zerrüttung geschützt. Ein Umgießen des elektronischen Bauelements mit einem Kunststoff bzw. einer Moldmasse zum Schutz der Kontaktstellen ist nicht mehr nötig. Damit kann bei der Herstellung des Bauteils sowohl Zeit als auch Material eingespart werden.

Die erfindungsgemäße Ausnehmung ist in dem ersten Abschnitt des Kontaktelements ausgebildet und weitestgehend oder vollständig dem Rahmenbereich, der ebenfalls Teil des ersten Abschnitts ist, umgeben. Das bedeutet insbesondere, dass die Ausnehmung nicht als Einschnitt am Rand des Kontaktelements ausgebildet ist. Die Abmessungen des erfindungsgemäßen Kontaktelements unterscheiden sich also im Wesentlichen nicht von einem herkömmlichen Kontaktelement.

Das Kontaktelement ist bevorzugt als Stanzblechteil aus einem elektrisch leitfähigen Material, wie beispielsweise Kupfer oder Aluminium ausgebildet. In einer bevorzugten Ausführung des erfindungsgemäßen Kontaktelements sind die Federelemente einteilig mit dem Rahmenbereicht ausgebildet. Diese Ausführung bietet den Vorteil, dass das erfindungsgemäße Kontaktelement in einfacher und kostensparender Weise aus einem Stück, beispielsweise einem dünnen Blech hergestellt werden kann. Die erfindungsgemäße Ausnehmung ist dabei so geformt, dass die Federelemente und Kontaktbereiche durch die Kontur der Ausnehmung gebildet werden. Die Ausnehmung kann in einfacher Weise, beispielsweise durch Ausstanzen, in dem Kontaktelement gebildet werden.

Die Federelemente sind bevorzugt als mäanderförmige Stege ausgebildet, die ausgehend vom Rand des Rahmenbereichs in die Ausnehmung hineinragen. Am Ende eines Federelements ist bevorzugt ein verbreiterter Bereich ausgebildet, der den jeweiligen Kontaktbereich bildet. Der Kontaktbereich ist demzufolge beweglich relativ zum Rahmenbereich.

Bevorzugt sind mehrere Federelemente und damit auch mehrere Kontaktbereiche vorgesehen. Damit ergeben sich viele kleinere Kontaktstellen zwischen dem Kontaktelement und einem zu kontaktierenden Bauelement, was die auftretenden thermischen Spannungen weiter reduziert.

Abhängig von der Geometrie des Bauteils, in dem das Kontaktelement zum Einsatz kommt, kann es erwünscht sein, den ersten Abschnitt des Kontaktelements bzw. den Rahmenbereich, die Kontaktbereiche und/oder den zweiten Abschnitt des Kontaktelements auf jeweils unterschiedlichen Ebenen auszubilden. Dazu können die Federelemente bespielweise in einem Winkel relativ zur Ebene des Rahmenbereichs verlaufen. Die Kontaktbereiche, die jeweils am Ende eines Federelements ausgebildet sind bevorzugt parallel zum Rahmenbereich ausgerichtet.

Das erfindungsgemäße Kontaktelement kann beispielsweise als Kontaktbügel oder als Schaltungsträger ausgebildet sein. Das Kontaktelement kann bevorzugt in einem elektronischen Bauteil zur Kontaktierung eines elektronischen Bauelements, insbesondere eines Halbleiterbauelements, verwendet werden. Das elektronische Bauelement weist mindestens eine Kontaktfläche auf. Typischerweise sind mehrere Kontaktflächen vorgesehen, die beispielsweise auf gegenüberliegenden, Oberflächen angeordnet sein können. Beispielsweise wird das Bauelement auf ein erstes Kontaktelement, das als Leiterrahmen ("Leadframe") ausgebildet ist, aufgelötet. Ein zweites Kontaktelement, das als Kontaktbügel ausgeführt ist, wird auf der Oberfläche des Bauelements kontaktiert.

Es ist vorteilhaft, wenn beispielsweise das erste, als Leiterrahmen ausgeführte, Kontaktelement erfindungsgemäß ausgebildet ist. Damit können Kräfte, die auf die Kontaktstellen zwischen den Kontaktflächen des elektronischen Bauelements und den Kontaktbreichen des Leiterrahmens wirken, durch Federelemente kompensiert werden können.

Alternativ oder zusätzlich kann auch das zweite, als Kontaktbügel ausgeführte, Kontaktelement, erfindungsgemäß ausgebildet sein.

Ein Umgießen des elektronischen Bauelements mit einem Kunststoff (Moldmaterial) zum Schutz der Kontaktstellen zwischen einem elektronischen Bauelement und einem erfindungsgemäß ausgebildeten Kontaktelement vor mechanischen Spannungen ist nicht mehr nötig, wodurch bei der Herstellung Zeit, Material und Energie eingespart werden kann.

In manchen Fällen kann jedoch trotzdem gewünscht sein, das Bauelement, zumindest teilweise, mit einer Kunststoffumhüllung (Ummoldung) zu versehen. In diesem Fall ist es vorteilhaft, wenn die Kunststoffumhüllung einen oder mehrere Freiräume oder Vertiefungen aufweist, die im Bereich der Kontaktstellen so angeordnet sind, dass die freie Beweglichkeit der Federelemente erhalten bleibt und thermische Spannungen kompensiert werden können.

### Kurze Beschreibung der Zeichnungen

Figur 1 zeigt im Schnitt ein elektronisches Bauteil mit einem Kontaktelement nach dem Stand der Technik.
Figur 2 zeigt im Schnitt ein elektronisches Bauteil nach einem bevorzugten Ausführungsbeispiel der Erfindung.
Figur 3 zeigt im Schnitt ein elektronisches Bauteil nach einem alternativen Ausführungsbeispiel der Erfindung.
Figur 4 zeigt ein erstes Ausführungsbeispiel für ein erfindungsgemäßes Kontaktelement in Draufsicht von unten.
Figur 5 zeigt ein zweites Ausführungsbeispiel für ein erfindungsgemäßes Kontaktelement in Draufsicht von unten.
Figur 6 a zeigt ein drittes Ausführungsbeispiel für ein erfindungsgemäßes Kontaktelement.

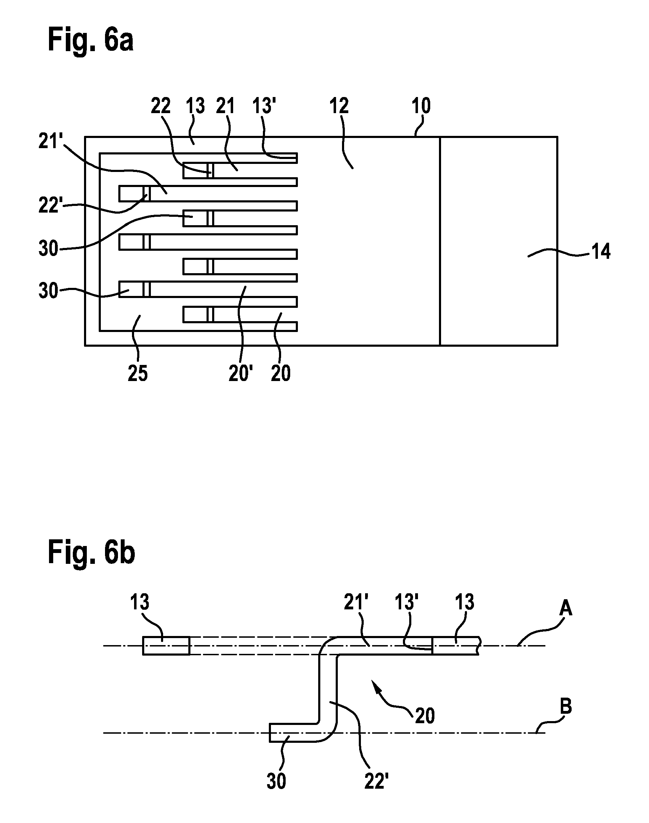

Figur 6 b zeigt ein einzelnes Federelement gemäß des Ausführungsbeispiels aus Figur 6 a in Seitenansicht.

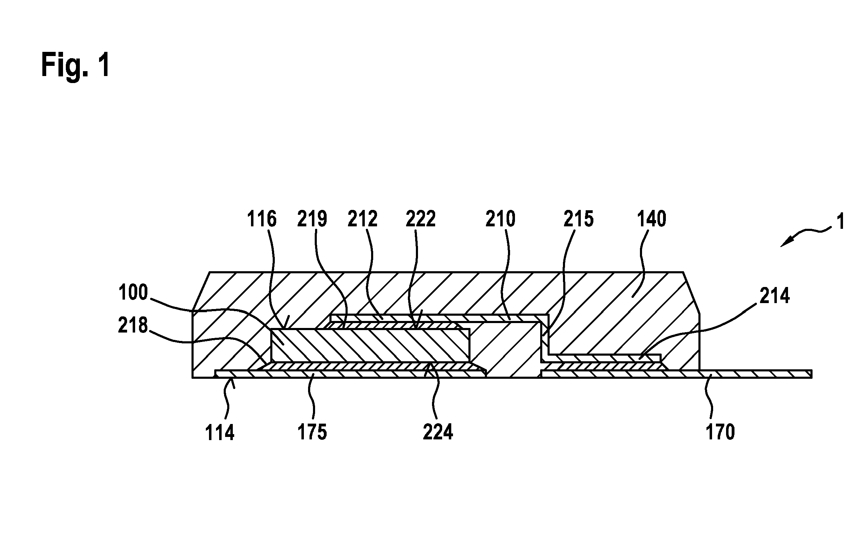

In Figur 1 ist ein elektronisches Bauteil 1 nach dem Stand der Technik dargestellt. Es weist ein Halbleiterbauelement 100 auf, bei dem es sich beispielsweise um einen Leistungstransistor, ein IGBT, oder ähnliches handeln kann. Das Halbleiterbauelement 100 ist mit einer Kontaktfläche 224 auf seiner Unterseite 114 elektrisch mit einem als Stanzgitter ausgeführten Schaltungsträger ("Leadframe") 175 über eine flächig ausgebildete Kontaktstelle 218 elektrisch kontaktiert.

Das elektronische Bauteil 1 weist ein zweites Stanzgitter 170 auf, das über ein als Kontaktbügel 210 ausgebildetes Kontaktelement mit einer Kontaktfläche 222 auf der Oberseite 216 des Halbleiterbauelements 100 elektrisch kontaktiert ist. Der Kontaktbügel 210 weist dazu zwei flächig ausgebildete Abschnitte 212 und 214 auf, wobei der erste Abschnitt 212 auf der Kontaktfläche 222 aufliegt und über eine einzige, flächig ausgebildete Kontaktstelle 219 elektrisch mit der Kontaktfläche 222 verbunden ist. Die Kontaktstellen 218 und 219 können als Lötverbindungen ausgeführt sein. Alternativ ist auch die Kontaktierung mit einem elektrisch leitfähigen Klebstoff denkbar. Der zweite Abschnitt 214 des Kontaktbügels 210 verläuft im Wesentlichen parallel zum ersten Abschnitt 212 und ist mit dem zweiten Stanzgitter 170 elektrisch verbunden. Sowohl der Kontaktbügel 210 als auch die Schaltungsträger 170 und 175, bestehen aus einem elektrisch leitfähigen Material, wie etwa Kupfer oder Aluminium. Die Kontaktstellen 218 und 219 zwischen dem Halbleiterbauelement 100 und dem Kontaktbügel 210 bzw. dem Schaltungsträger 175 sind im Wesentlichen flächig ausgebildet. Durch die unterschiedlichen thermischen Ausdehnungskoeffizienten des Halbleitermaterials und des Materials des Kontaktbügels 210 bzw. des Schaltungsträgers 175 können im Betrieb des Halbleiterbauelements 100 Scherkräfte auftreten, die auf die Kontaktstellen 218 und 219 wirken, und die im Extremfall eine Zerrüttung der Kontaktstellen 218 und 219 zur Folge haben. Aus diesem Grund ist das Halbleiterbauelement 100 mit einer Moldmasse 140 umgossen. Die beiden Schaltungsträger 175 und 170 sind teilweise in die Moldmasse 140 eingebettet.

### Ausführungsformen der Erfindung

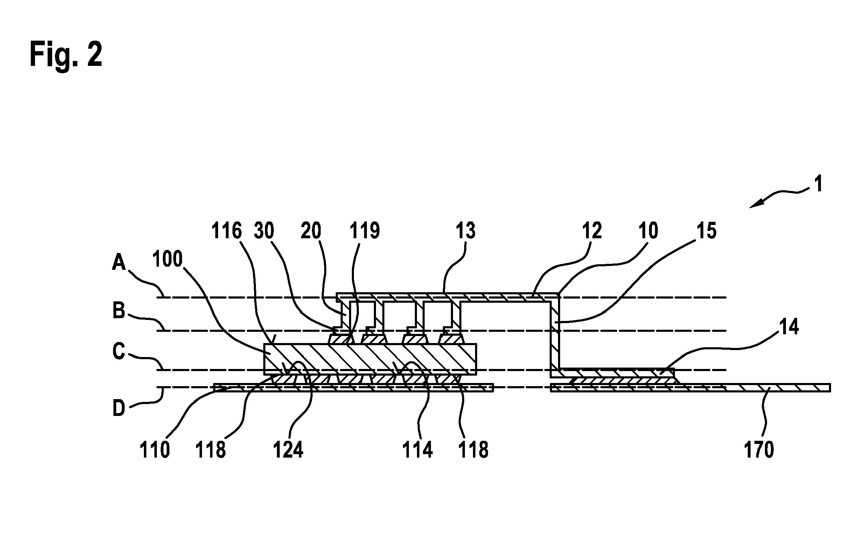

In Figur 2 ist ein ist ein elektronisches Bauteil 1 nach einem bevorzugten Ausführungsbeispiel der Erfindung im Schnitt dargestellt.

Das Halbleiterbauelement 100 ist mit einer Kontaktfläche 124 auf seiner Unterseite 114 elektrisch mit einem als Stanzgitter ausgeführten

Schaltungsträger 110 über Kontaktstellen 118 elektrisch kontaktiert. Das Stanzgitter 170 ist über ein als Kontaktbügel 10 ausgebildetes Kontaktelement kontaktiert. Dazu sind zwischen Kontaktflächen 122 auf der Oberseite 116 des Halbleiterbauelements 100 und Kontaktbereichen 30 des Kontaktbügels 10 Kontaktstellen 119 ausgebildet. Der Kontaktbügel 10 weist einen ersten Abschnitt 12 und einen zweiten Abschnitt 14 auf. Der zweite Abschnitt 14 verläuft im Wesentlichen parallel zum ersten Abschnitt 12 und ist mit dem zweiten Stanzgitter 170 elektrisch verbunden.

Aufgrund der Bauhöhe des Halbleiterbauelements 100 sind der erste Abschnitt 12 und der zweite Abschnitt 14 in unterschiedlichen Ebenen A und C ausgebildet. Der erste Abschnitt 12 ist mit dem zweiten Abschnitt 14 über einen Verbindungsabschnitt 15 verbunden, der im Wesentlichen senkrecht zu den Abschnitten 12 und 14 verläuft. Alternativ kann der Kontaktbügel 10 auch in einer Ebene ausgeführt sein. Die Kontaktbereiche 30 sind in einer Ebene B ausgebildet, die im Wesentlichen parallel zur Ebene A verläuft. Die Kontaktbereiche 30 sind über Kontaktstellen 119, mit den Kontaktflächen 122 auf der Oberfläche 116 des Halbleiterbauelements 100 elektrisch kontaktiert.

Die Kontaktstellen 118 und 119 sind üblicherweise Löt- oder Klebestellen. Um eine Zerrüttung der Kontaktstellen 118 und 119 durch thermische Spannungen zu vermeiden, sind in dieser Ausführung sowohl der Kontaktbügel 10, als auch der Schaltungsträger 110 als erfindungsgemäße Kontaktelemente ausgebildet. Alternativ kann auch nur der Kontaktbügel 10 oder nur den Schaltungsträger 110 erfindungsgemäß ausgestaltet sein.

Der Kontaktbügel 10 weist erfindungsgemäß im Abschnitt 12 mindestens eine, in dieser Ansicht nicht sichtbare, Ausnehmung 25 auf. Die Ausnehmung 25 ist von einem Rahmenbereich 13 vollständig umgeben und enthält mehrere Federelemente 20, die einteilig mit dem Rahmenbereich 13 ausgebildet sind. Der Abschnitt 12 und damit auch der Rahmenbereich 13 des Kontaktelements 10 ist in diesem Beispiel in einer Ebene A ausgebildet, die deutlich oberhalb der Oberfläche 116 des Halbleiterbauelements 100 verläuft. Die Federelemente sind, ausgehend von der Ebene A in Richtung der Oberfläche 116 des Halbleiterbauelements 100 gebogen. An den freien Enden der Federelemente 20 sind Kontaktbereiche 30 ausgebildet. Die Kontaktbereiche 30 sind so angeordnet, dass sie die Kontaktflächen 122 des Halbleiterbauteils 100 zumindest teilweise überdecken.

Das Kontaktelement 10 ist beispielsweise als Stanzblechteil ausgeführt. Bei der Herstellung wird zunächst eine strukturierte Ausnehmung aus einem flachen Blechteil herausgestanzt, wodurch die Federelemente 20 und die Kontaktbereiche 30 geformt werden. In einem oder mehreren anschließenden Biegeschritten wird die Ausbildung der verschiedenen Ebenen A, B und C erzielt. Alternativ kann die Ausbildung der verschiedenen Ebenen A, B und C auch während des Aufbringens des Kontaktbügels 10 erfolgen.

Scherkräfte, die durch die unterschiedlichen thermischen Ausdehnungskoeffizienten des Materials des Halbleiterelements 100 und des Materials des Kontaktelements 10 verursacht werden, werden durch die Federelemente kompensiert, so dass eine Belastung und damit eine Zerrüttung der Kontaktstellen 119 vermieden wird. Die Federelemente können dazu beispielsweise eine Mäanderform aufweisen.

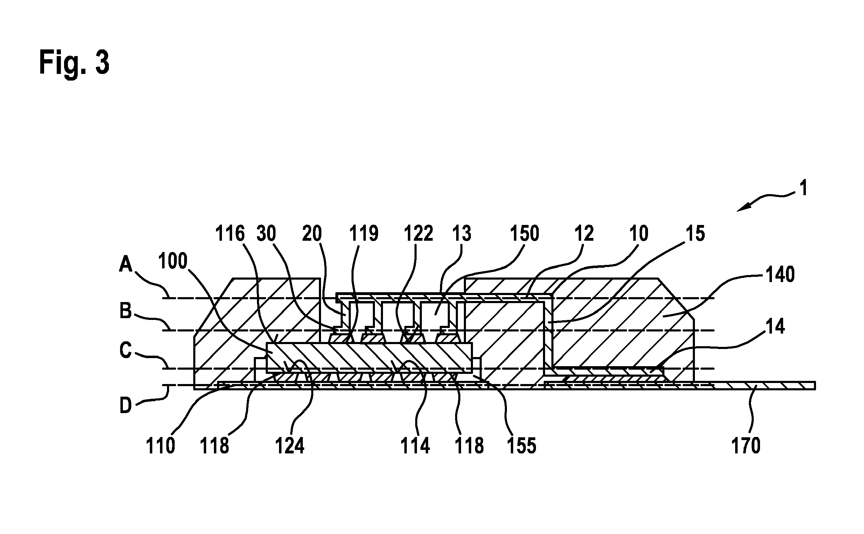

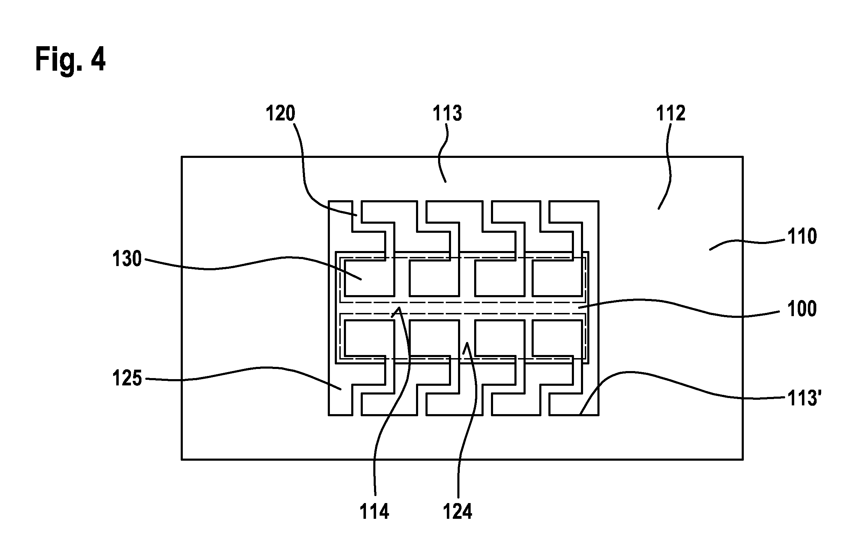

Auch der Schaltungsträger 110 ist in diesem Ausführungsbeispiel als erfindungsgemäßes Kontaktelement ausgebildet. Die Federelemente 120, die in dem Schaltungsträger 110 ausgebildet sind, sind in der Ansicht der Figur 2 nicht sichtbar. Mögliche Ausgestaltungen sind in den Figuren 3 und 4 gezeigt. An den Enden jedes Federelements 120 ist jeweils ein Kontaktbereich 130 ausgebildet. Die Kontaktbereiche sind über die Kontaktstellen 118 mit Kontaktbereichen 124 auf der Unterseite 114 des elektronischen Bauelements 100 kontaktiert.

Eine komplette Ummoldung des Halbleiterbauelements 100 ist bei der Verwendung von erfindungsgemäß ausgebildeten Kontaktelementen 10 und 110 nicht mehr nötig, um eine Zerrüttung der Kontaktstellen 118 und 119 zu vermeiden.

Um beispielsweise die Stabilität des elektronischen Bauteils 1 zu verbessern oder eine einfachere Handhabung des elektronischen Bauteils 1 zu erzielen, kann es trotzdem gewünscht sein, das Halbleiterbauelements und/oder die Schaltungsträger zumindest teilweise mit einer Moldmasse abzudecken. Ein entsprechendes Bauteil 1 ist in Figur 3 dargestellt. Der Aufbau des gezeigten Bauteils 1 entspricht im Wesentlichen dem in Figur 2 dargestellten Bauteil. Gleiche Elemente sind mit gleichen Bezugszeichen versehen. Das Halbleiterbauelement 100 und die Schaltungsträger 110 und 170 sind teilweise mit einer Moldmasse 140 abgedeckt. Um trotzdem eine freie Beweglichkeit der Federelemente 20 und 120 zu gewährleisten, und damit die Kompensation von Kräften auf die Kontaktstellen 118 und 119 zu ermöglichen, können in diesem Fall ein oder mehrere Freiräume 150 bzw. 155 in der Moldmasse 140 gebildet sein. Der Freiraum 150 ist in diesem Beispiel als Vertiefung im Bereich der Federelemente 20 bzw. der Kontaktstellen 119 ausgebildet. Der Freiraum 155 ist als Hohlraum im Bereich der Federelemente 120 bzw. der Kontaktstellen 118 ausgebildet. Alternativ kann der Freiraum 150 auch anders ausgebildet sein, so dass beispielsweise das gesamte Halbleiterbauelement 100 frei von Moldmasse 140 ist.

Figur 4 zeigt eine mögliche Ausgestaltung eines erfindungsgemäßen Kontaktelements in Draufsicht von unten. Diese Ausgestaltung eignet sich insbesondere als Schaltungsträger 110 in dem in den Figuren 2 und 3 dargestellten elektronischen Bauteil 1. In einem Abschnitt 112 des Schaltungsträgers 110 ist eine strukturierte Ausnehmung 125 eingebracht. Die Ausnehmung 125 ist in diesem Beispiel vollständig von einem Rahmenbereich 113 umgeben. In der Ausnehmung 125 sind in diesem Beispiel acht Federelemente 120 ausgebildet. Die Anzahl und Ausrichtung der Federelemente hängt im Allgemeinen von der Anordnung der Kontaktflächen des Bauelements 100 ab. Die Federelemente 120 sind einteilig mit dem Rahmenbereich 113 ausgeführt und mit dem Rand 113' des Rahmenbereichs 113 verbunden. An den Enden jedes Federelements 120 ist jeweils ein Kontaktbereich 130 in Form einer im Wesentlichen rechteckigen Fläche ausgebildet. Alternativ ist es denkbar, die Kontaktbereiche 130 rund, oval oder in jeder beliebigen Form auszubilden. Die Kontaktbereiche 130 sind so angeordnet, dass sie auf die Kontaktflächen 124 des Halbleiterbauteils 100 ausgerichtet sind und die Kontaktflächen 124 zumindest teilweise überdecken.

Die Federelemente 120 sind in diesem Beispiel im Wesentlichen S-förmig ausgebildet. Diese Form erlaubt eine Kompensation von Scherkräften in der Ebene D der Kontaktelemente 130, als auch von Kraftkomponenten senkrecht zu dieser Ebene durch die elastischen Eigenschaften der Federelemente 120. Alternativ können die Federelemente 120 auch mit einer höheren Anzahl von Windungen ausgeführt werden um die Federkonstante an die erwarteten Kräfte anzupassen. Auch andere Ausführungsformen der Federelemente sind denkbar, beispielsweise U-, mäander- oder spiralförmig.

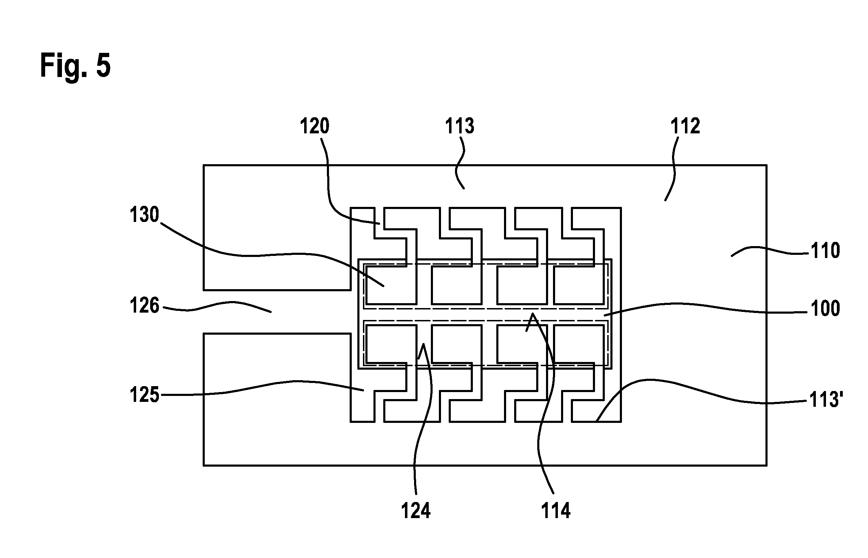

In Figur 5 ist zeigt eine alternative Ausgestaltung des Schaltungsträgers 110. Der Aufbau entspricht im Wesentlichen der Figur 3. Im Unterschied zur Figur 3 weist der Schaltungsträger 110 in diesem Beispiel eine Ausnehmung 125 auf, die nur teilweise von dem Rahmenbereich 113 umgeben ist. Der Rahmenbereich 133 weist einen Einschnitt 126 auf, der mit der Ausnehmung 125 verbunden ist. Der Einschnitt 126 kann beispielsweise nötig sein, um, bei Verwendung des Schaltungsträgers 110 in einem elektronischen Bauteil, Platz für benachbarte Bauelemente zu schaffen, oder die Montage zu erleichtern.

Ein Beispiel für eine mögliche Ausbildung für eines erfindungsgemäßes Kontaktelement, das insbesondere als Kontaktbügel 10 in dem in Figur 2 dargestellten elektronischen Bauteil 1 verwendet werden kann, ist in Figur 6 a schematisch in Draufsicht dargestellt. Der Kontaktbügel 10 weist erfindungsgemäß einen Abschnitt 12 mit s einer Ausnehmung 25 auf. Die Ausnehmung 25 ist von einem Rahmenbereich 13 umgeben und enthält mehrere Federelemente 20 und 20', die einteilig mit dem Rahmenbereich 13 ausgebildet sind. Die Federelemente 20 sind in diesem Beispiel vollständig von dem Rahmenbereich 13 umgeben. Alternativ kann der Rahmenbereich auch einen Einschnitt aufweisen.

Die Federelemente sind fingerartig ausgebildet, und weisen jeweils ein erstes Teilstück 21 bzw. 21' auf, das im Wesentlichen parallel zum Abschnitt 12 des Kontaktelements ausgebildet ist, sowie ein zweites Teilstück 22 bzw. 22', das im Wesentlichen rechtwinklig zum dem ersten Teilstück 21 bzw. 21' verläuft. Die Teilstücke 21, 21', 22 und 22' sind jeweils als gerade Stege ausgebildet. Alternativ kann jedoch auch eine Mäanderstruktur vorgesehen sein. Jeweils am freien Ende der Teilstücke 22 und 22' sind Kontaktbereiche 30 ausgebildet, die mit Kontaktflächen eines nicht dargestellten elektronischen Bauelements elektrisch kontaktiert werden können. Die zweiten Teilstücke 22 bzw. 22' sind in dieser Ansicht verkürzt dargestellt. Federelemente 20 mit kurzen ersten Teilstücken 21 und Federelemente 20' mit langen ersten Teilstücken 21' sind alternierend angeordnet, um die Stromdichte an der Oberfläche 116 des elektronischen Bauelements 100 gering zu halten, bzw. die Stromaufnahmebereiche flächig zu verteilen. Somit ergibt sich eine kammartige Struktur. Alternativ ist es auch vorstellbar, alle Federelemente 20 und 20' gleichförmig auszubilden.

Figur 6 b zeigt eines der Federelemente 20' aus dem in Figur 6 a beschriebenen Beispiel in Seitenansicht. In dieser Ansicht wird die Struktur des Federelements deutlich. Das erste Teilstück 21' verläuft eben mit dem Randbereich 13. Die Teilstücke 21' und 22' verlaufen im Wesentlichen senkrecht zueinander. Wenn im eingebauten und kontaktierten Zustand Kräfte auf den Kontaktbereich 30 ausgeübt werden, so kann sich das Federelement 20' verformen. Bei Scherkräften parallel zur Ebene B des Kontaktbereichs 30 kann sich der Winkel, der zwischen dem ersten Teilstück 21' und dem zweiten Teilstück 22' gebildet wird, beispielsweise vergrößern oder verkleinern. Bei Kräften senkrecht zur Ebene des Kontaktbereichs 30 kann eine Verformung am Rand 13' des Rahmenbereichs 13 auftreten. Für die kürzer ausgebildeten Federelemente 20 gilt eine analoge Betrachtung. Die, insbesondere bei Temperaturwechsel, auftretenden Kräfte können so kompensiert werden. Kontaktstellen, die zwischen den Kontaktbereichen 30 und Kontaktflächen eines elektronischen Bauelements ausgebildet sind, sind demzufolge vor Zerrüttung geschützt.

## Patentansprüche

1. Kontaktelement (10, 110), das
- einen ersten Abschnitt (12, 112) zur elektrischen Kontaktierung eines elektronischen Bauelements (100) aufweist, wobei
- in dem ersten Abschnitt (12, 112) mindestens ein Federelement (20, 120) ausgebildet ist und auf oder in direkter Verbindung mit mindestens einem der Federelemente (20, 120) mindestens ein Kontaktbereich (30, 130) ausgebildet ist.
**dadurch gekennzeichnet, dass**
- das der erste Abschnitt (12, 112) des Kontaktelements (10, 110) einen Rahmenbereich (13, 113) mit mindestens einer Ausnehmung (25, 125) aufweist, wobei
- die Ausnehmung (25, 125) wenigstens teilweise von dem Rahmenbereich (13, 113) umgeben ist, und wobei
- die Ausnehmung (25, 125) mindestens einen Kontaktbereiche (30, 130) und mindestes ein Federelement (20, 120) enthält, und
- das Federelement (20, 120) mit dem Rand (13', 113') des Rahmenbereichs (13, 113) verbunden ist.

2. Kontaktelement (10, 110) nach Anspruch 1, **dadurch gekennzeichnet, dass** mindestens ein Federelement (20, 120) einteilig mit dem Randbereich (13, 113) ausgebildet ist.

3. Kontaktelement (110) nach einem der Ansprüche 1 oder 2, **dadurch gekennzeichnet, dass** mindestens ein Kontaktbereich (130) in einer Ebene (D) ausgebildet ist, die gleich der der Ebene (D) des Rahmenbereichs (113) bzw. des ersten Abschnitts (112) ist.

4. Kontaktelement (10) einem der Ansprüche 1 oder 2, **dadurch gekennzeichnet, dass** mindestens ein Kontaktbereich (30) in einer Ebene (B) ausgebildet ist, die verschieden von der Ebene (A) des Rahmenbereichs (13) bzw. des ersten Abschnitts (12) ist.

5. Kontaktelement (10) nach einem der Ansprüche 1 bis 4, **dadurch gekennzeichnet, dass** der erste Abschnitt (12) und ein zweiter Abschnitt (14) des Kontaktelements (10) in verschiedenen Ebenen (A, C) ausgebildet sind.

6. Kontaktelement (110) nach einem der Ansprüche 1 bis 5, **dadurch gekennzeichnet, dass** das Federelement (120) mäanderförmig ausgebildet ist.

7. Kontaktelement (10, 110) nach einem der Ansprüche 2 bis 6, **dadurch gekennzeichnet, dass** eine Ausnehmung (25, 125) mehrere Federelemente (20, 120) enthält.

8. Kontaktelement (10, 110) nach einem der Ansprüche 1 bis 7, **dadurch gekennzeichnet, dass** das Kontaktelement (10, 110) als Stanzblechteil, insbesondere aus Kupfer oder Aluminium, ausgebildet ist.

9. Verwendung eines Kontaktelements (10, 110) nach einem der Ansprüche 1 bis 8 in einem elektronischen Bauteil (1),
- das mindestens ein elektronisches Bauelement (100), insbesondere ein Leistungshalbleiterelement, aufweist, wobei
- das elektronisches Bauelement Kontaktflächen (122, 124) aufweist,
**dadurch gekennzeichnet, dass**
- mindestens ein Kontaktbereich (30, 130) des Kontaktelements (10, 110) mit mindestens einer Kontaktfläche (122, 124) des elektronisches Bauelements (100) durch eine Kontaktstelle (118, 119) elektrisch verbunden ist.

10. Verwendung eines Kontaktelements (10) nach Anspruch 9, **dadurch gekennzeichnet, dass** das elektronische Bauelement (100) wenigstens teilweise von einer Moldmasse (140) bedeckt ist, wobei die Moldmasse (140) mindestens einen Freiraum (150, 155) aufweist, der im Bereich der Kontaktflächen (122, 124) des elektronischen Bauelements (100) angeordnet ist und der mindestens ein Federelement (20, 120) eines Kontaktelements (10, 110) enthält.
